# EUROPÄISCHE PATENTSCHRIFT

(11) **EP 1 328 022 B1**
(45) Veröffentlichungstag und Bekanntmachung des Hinweises auf die Patenterteilung: **07.03.2007**
(21) Anmeldenummer: 02027154.0
(22) Anmeldetag: 05.12.2002
(51) Int. Cl.: H01L 23/473, H05K 7/14, H05K 7/20

(54) **Kühlvorrichtung für elektronische Bauteile**
Cooling apparatus for electronic devices
Dispositif de refroidissement pour composants électroniques

(30) Priorität: 14.01.2002 DE 20200484 U
(43) Veröffentlichungstag der Anmeldung: 16.07.2003
(73) Patentinhaber: AMK Arnold Müller GmbH & Co.KG, 73230 Kirchheim / Teck (DE)
(72) Erfinder: Müller, Arnold, 73230 Kirchheim/Teck (DE); Vogt, Günther, Dr., 73230 Kirchheim/Teck (DE)
(74) Vertreter: Kratzsch, Volkhard

(56) Entgegenhaltungen:
- CH-A- 677 293
- DE-A- 3 522 127
- DE-A- 4 210 834
- US-A- 4 072 188
- PATENT ABSTRACTS OF JAPAN Bd. 2000, Nr. 05, 14. September 2000 (2000-09-14) -& JP 2000 042667 A (RYOSAN CO LTD), 15. Februar 2000 (2000-02-15)
- PATENT ABSTRACTS OF JAPAN Bd. 013, Nr. 126 (E-734), 28. März 1989 (1989-03-28) -& JP 63 293865 A (NEC CORP), 30. November 1988 (1988-11-30)
- PATENT ABSTRACTS OF JAPAN Bd. 2000, Nr. 23, 10. Februar 2001 (2001-02-10) -& JP 2001 168569 A (CALSONIC KANSEI CORP; NISSAN MOTOR CO LTD), 22. Juni 2001 (2001-06-22)
- PATENT ABSTRACTS OF JAPAN Bd. 1996, Nr. 07, 31. Juli 1996 (1996-07-31) -& JP 08 064731 A (HITACHI LTD), 8. März 1996 (1996-03-08)
- PATENT ABSTRACTS OF JAPAN Bd. 2000, Nr. 24, 11. Mai 2001 (2001-05-11) -& JP 2001 203487 A (MITSUBISHI ELECTRIC CORP), 27. Juli 2001 (2001-07-27)

## Beschreibung

Die Erfindung bezieht sich auf eine Kühlvorrichtung für Bauteile, insbesondere für elektrische oder elektronische Bauteile, wie Stromrichter od. dgl., die mit einem Kühlkörper in Berührung stehen.

Es ist bekannt, elektronische Hochleistungsbauteile mit einem eigenen Kühlkörper zu versehen, der z. B. mit Kühlrippen versehen ist, wodurch die mit der Umgebungsluft zur Wärmeabfuhr in Berührung stehende Oberfläche vergrößert wird. Kühlvorrichtungen dieser Art sind bei vielen Hochleistungsbauteilen unzulänglich, so dass es erforderlich ist, das Innere eines Schaltschranks, in dem sich viele solche Bauteile befinden, mittels eines besonderen Schaltschrankkühlers zu kühlen. Mittels eines solchen Schaltschrankkühlers wird aus dem Inneren des Schaltschranks Warmluft abgeführt, die nach Passieren des Kühlers als Kaltluft wieder in den Schaltschrank eingeleitet wird. Ein solcher Schaltschrankkühler hat einen gewissen Platzbedarf und ist relativ kostenaufwendig. Mitunter ist ferner von Nachteil, dass dadurch im Inneren des Schaltschranks ein Luftstrom erzeugt wird.

Es ist eine Kühlvorrichtung der eingangs genannten Art bekannt (DE 4131739 A1), die zur Kühlung elektrischer oder elektronischer Bauteile dient, welche mit einem Kühlkörper in Berührung stehen, der aus einer wärmeleitenden Platte besteht. Die Platte hat auf einer Breitseite eine nutartige Vertiefung in Form einer Aussparung, die ringsum durch hochstehende Ränder der Platte begrenzt ist. Innerhalb der Vertiefung ist, darin eingebettet, ein von einem Kühlmedium durchströmter Wärmeaustauscher als Kühler ausgebildet, mit einer Einlage, die aus einem gewellten Metallblech besteht, wobei die Wellen quer zur Durchströmungsrichtung des Kühlmediums verlaufen. Diese Einlage aus gewelltem Metallblech umfasst eine Vielzahl von Reihen, bei denen jeweils aufeinanderfolgende Reihen seitlich gegeneinander versetzt sind. Die Einlage endet in Abstand von den ringsum verlaufenden, überstehenden Rändern der Vertiefung. Dieser Abstand soll eine günstige Verteilung des Kühlmediums über die gesamte Breite der Vertiefung ermöglichen. Die Einlage ist aus gewelltem Band hergestellt und an der Platte angelötet, die somit einen Wandteil des Kühlers bildet. Bei dieser Einlage handelt es sich daher nicht um ein eigenständiges plattenartiges Gebilde, sondern, vor der Lötbefestigung, um eine in sich labile Wellenanordnung, die erst durch die Lötbefestigung an der Platte Stabilität erlangt. Die Einlage ist nicht auswechselbar.

Aus DE 4210834 A ist eine Kühlvorrichtung bekannt, bei der der Kühlkörper aus einer mit Kühlkanälen versehenen Kühlplatte gebildet ist. Dieser Kühlkörper weist keinen eigenständigen, austauschbaren Wärmeaustauscher auf. Die Kühlplatte hat einen überstehenden Rand mit einer darin enthaltenen, rundum verlaufenden Nut, in der eine Membran, die an ihren Rändern umgeklappt ist, flüssigkeitsdicht gehalten ist. Die Membran deckt in der Kühlplatte enthaltene Kühlkanäle ab und verhindert ein Austreten des darin geführten Kühlmediums. Die Membran hat eine federnde Wirkung. An der Membran liegen die Rückseiten der zu kühlenden Bauelemente an. Eine gute Wärmeableitung soll dadurch gewährleistet sein, dass die Membran genügend dünn ist, z.B. etwa 0,1 mm beträgt, um trotz vorhandener Höhenunterschiede an den Bauelementen möglichst dicht anzuliegen. Die Kühlplatte mit den darin gebildeten Kühlkanälen und der Abdeckung durch die Membran stellt einen Wärmeaustauscher üblicher Art dar. Eine damit ähnliche Kühlvorrichtung ergibt sich auch aus DE 3522127 A. Diese Kühlvorrichtung weist eine Kühlplatte auf, die selbst als Wärmeaustauscher ausgebildet ist. Sie enthält einen mäanderförmigen, eingetieften Kühlkanal, der zur Breitseite der Kühlplatte offen ist und dort mittels einer Platte abgedeckt und abgedichtet ist, so dass das im Kühlkanal geführte Kühlmedium nicht austreten kann, sondern den Weg entlang des Kühlkanalverlaufs nehmen kann. Auf der gegenüberliegenden Seite der Kühlplatte sind die zu kühlenden Bauelemente in der Weise angebracht, dass diese mit Vorsprüngen in Nuten von Führungsschienen eingebracht werden und gehalten sind. Diese Führungsschienen sollen mit Hilfe nicht dargestellter Klemmorgane, die in Seitenteilen enthalten sind, quer zur Längsachse und zu der Kühlfläche der Kühlplatte hin bewegbar sein, der Art, dass die eingeschobenen Bauelemente an die Kühlfläche der Kühlplatte angedrückt werden. Hinsichtlich der dies bewirkenden Elemente ist von üblichen Klemmorganen, wie Exzentern, Keilen oder Federn die Rede. Nachteilig ist auch bei dieser Kühlvorrichtung, dass diese keinen eigenständigen auswechselbaren Wärmeaustauscher aufweist. Eine Kühlvorrichtung ähnlicher Art ist ferner aus CH 677293 A5 ersichtlich. Auch diese weist eine metallische Kühlplatte auf, die zu einer Breitseite offene, mäanderförmig verlaufende Kühlkanäle enthält. In diese Kühlkanäle ist ein Isolierschlauch eingelegt, der einerseits elektrisch ausreichend isolieren soll und andererseits gleichzeitig relativ gut wärmeleitend sein soll. Der Isolierschlauch soll durch Wasserdruck an die Wandungen des inneren Kühlkanals einerseits und an die anliegende Fläche eines an der Kühlplatte anliegenden, zu kühlenden Bauteils andererseits angepresst werden, um einen guten Wärmefluss zu erzeugen. Der Isolierschlauch hat eine Schlauchdicke im Bereich von 0,05 mm bis 0,2 mm und stellt damit ein labiles Element dar. Er ist nicht vergleichbar mit einem Wärmeaustauscher. Der Isolierschlauch ist an einen Einlass und einen Auslass angeschlossen, an die Wasserschläuche angeschlossen sind. Ein etwaiges Auswechseln des Isolierschlauches würde bedingen, dass dieser sowohl am Einlass als auch am Auslass abgelöst werden müsste, was aufwändig erscheint, soweit dies überhaupt möglich sein sollte. Der Isolierschlauch als labiles Bauteil hat keine feste Struktur. Daher ist an eine Austauschbarkeit in keiner Weise zu denken.

Bekannt ist ferner eine Kühlvorrichtung (Patent Abstracts of Japan Bd. 013, Nr. 126 (E-734), 28. März 1989 (1989-03-28) -& JP 63 293865 A (Nec Corp), 30. November 1988 (1988-11-30), mit einer Platte, die eine ringsum umrandete Aufnahme für eine metallische Rohrschlange aufweist, die in dieser Aufnahme platziert ist. In die Aufnahme ist hiernach eine Wärmeaustauschflüssigkeit eingebracht worden. Mittels der Rohrschlange, die von Kühlwasser durchflossen wird, soll einem zu kühlenden Bauteil Wärme entzogen werden. Für einen etwaigen Austausch der Rohrschlange bedarf es der Öffnung der Kühlvorrichtung und zunächst der Entnahme der Wärmeaustauschflüssigkeit. Nach diesem Austausch muss neue Wärmeaustauschflüssigkeit eingefüllt werden. Dies ist aufwändig.

Der Erfindung liegt die Aufgabe zugrunde, eine Kühlvorrichtung der eingangs genannten Art zu schaffen, die platzsparend und kostengünstig ist und eine intensive Kühlung mindestens eines Bauteils ermöglicht, so dass auf einen besonderen Schaltschrankkühler verzichtet werden kann.

Die Aufgabe ist bei einer Kühlvorrichtung der eingangs genannten Art gemäß der Erfindung durch die Merkmale im Anspruch 1 gelöst. Weitere vorteilhafte Erfindungsmerkmale und Ausgestaltungen ergeben sich aus den Unteransprüchen.

Die erfindungsgemäße Kühlvorrichtung bewirkt über die Kontaktkühlung eine sehr intensive Kühlung mindestens eines auf einer Trägerplatte gehaltenen Bauteils, wobei diese Kühlung von der Umgebungsluft und der Umwelt im wesentlichen völlig unabhängig ist. Die Kühlvorrichtung hat den Vorteil, dass das Innere eines Schaltschranks nicht belüftet werden muss und somit auf einen solchen herkömmlichen Schaltschrankkühler in der Regel verzichtet werden kann. Die Kühlvorrichtung ist einfach, platzsparend und kostengünstig. Sie lässt sich außerhalb des Schaltschranks befestigen, so dass sie von außen frei zugänglich ist, ohne dass umfangreiche Montagearbeiten notwendig sind. Zu etwaigen Reparatur- und/oder Wartungszwecken braucht lediglich die Trägerplatte mit dem mindestens einen daran gehaltenen Bauteil entfernt zu werden, so dass ein guter Zugang zum Wärmeaustauscher des Kühlkörpers geschaffen ist. Wenn der Wärmeaustauscher auf der dem mindestens einen Bauteil abgewandten Seite der Platte angeordnet ist, ist selbst diese Demontage der Trägerplatte mit daran gehaltenem mindestens einem Bauteil entbehrlich. Die Kühlvorrichtung gemäß der Erfindung wirkt nach dem Prinzip der Kontaktkühlung, wobei über den guten Körperkontakt zwischen dem Kühlkörper einerseits und der mit dem mindestens einem Bauteil versehenen Trägerplatte andererseits die Verlustwärme vom Bauteil durch Kontaktkühlung abgeleitet wird. Die mit der Umgebungsluft in Verbindung stehende freie Außenseite des Kühlkörpers leitet die Wärme an die Umgebungsluft ab, ohne dass es einer besonderen Zwangsbelüftung im Inneren des Schaltschranks oder auch außerhalb dieses bedarf. Von Vorteil ist ferner, dass auf einem einzigen Kühlkörper, insbesondere dessen Platte, eine Vielzahl einzelner Bauteile angeordnet werden kann, wobei diese einzelnen Bauteile mit Vorzug jeweils an einer eigenen Trägerplatte befestigt sind. Vorteilhaft ist ferner, dass die Kühlvorrichtung für einen mehrere Bauteile tragenden Kühlkörper nur eine Zuleitung für das Kühlmedium und eine Ableitung für das Kühlmedium benötigt und somit auch nur die dafür nötigen Anschlüsse zum Anschluss des Wärmeaustauschers daran. Der Wärmeaustauscher bleibt mit diesen Anschlüssen bleibend verbunden, wobei diese Anschlüsse auch dann nicht gelöst werden müssen, wenn z. B. einzelne Bauteile entfernt oder ausgetauscht werden müssen. Dies hat auch den Vorteil, dass nicht die Gefahr besteht, dass beim etwaigen Lösen der Anschlüsse der das Kühlmedium führenden Leitungen Kühlmedium in unerwünschter Weise austritt und eventuell in einen Schaltschrank gelangt. Dadurch gestaltet sich zugleich auch ein Austausch oder Wechsel einzelner Bauteile durch Demontage vom Kühlkörper besonders einfach und sicher, der sich außerdem problemlos und sehr schnell bewerkstelligen lässt. Die Kühlvorrichtung macht es ferner möglich, die das Kühlmedium führenden Leitungen außerhalb des Schaltschranks anzuordnen und zu führen. Da an einem Kühlkörper eine Vielzahl einzelner Bauteile angeordnet werden kann, ist der Aufwand für die Kühlung der Bauteile besonders gering.

Weitere Einzelheiten und Vorteile der Erfindung ergeben sich aus der nachfolgenden Beschreibung.

Der vollständige Wortlaut der Ansprüche ist vorstehend allein zur Vermeidung unnötiger Wiederholungen nicht wiedergegeben, sondern statt dessen lediglich durch Hinweis auf die Ansprüche darauf Bezug genommen, wodurch jedoch alle diese Anspruchsmerkmale als an dieser Stelle ausdrücklich und erfindungswesentlich offenbart zu gelten haben.

Die Erfindung ist nachfolgend anhand von in den Zeichnungen gezeigten Ausführungsbeispielen näher erläutert. Es zeigen:
- Fig. 1: eine schematische, teilweise geschnittene Seitenansicht einer Kühlvorrichtung für Bauteile und eines Teils eines Schaltschranks gemäß einem ersten Ausführungsbeispiel,
- Fig. 2: eine schematische, teilweise geschnittene Seitenansicht entsprechend derjenigen in Fig. 1 eines zweiten Ausführungsbeispiels,
- Fig. 3: eine schematische Seitenansicht lediglich des Kühlkörpers in Pfeilrichtung III in Fig. 1.

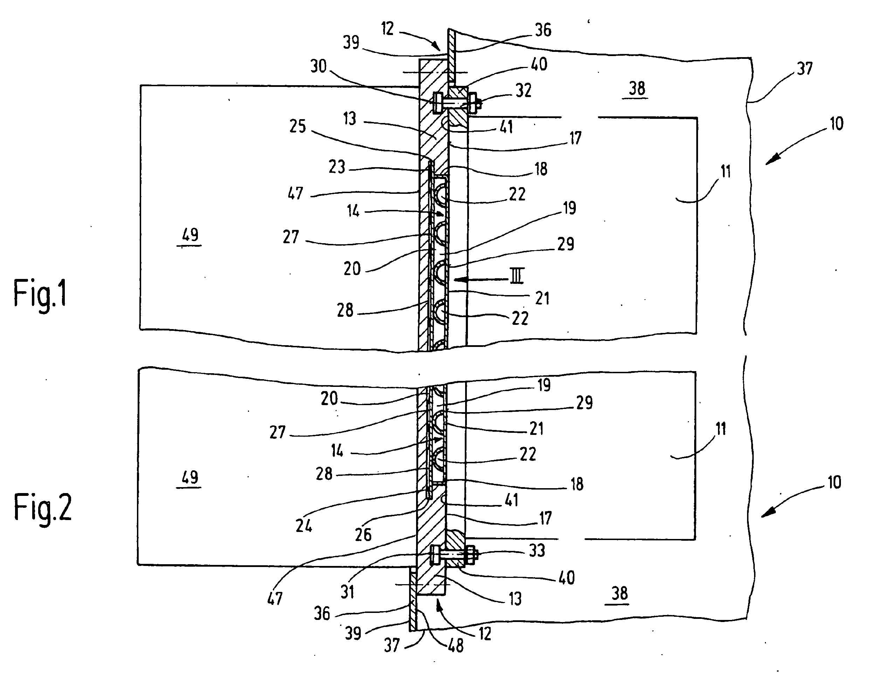

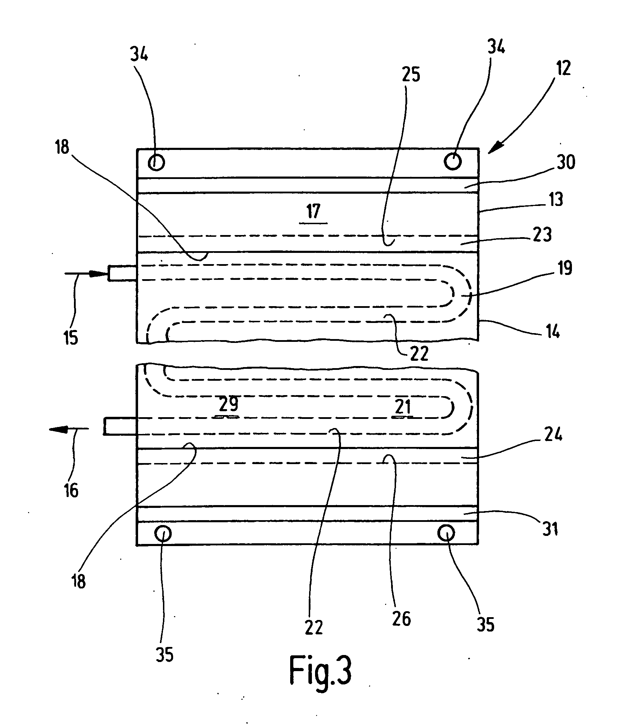

In Fig. 1 und 3 ist schematisch ein erstes Ausführungsbeispiel einer Kühlvorrichtung 10 gezeigt, die für Bauteile, insbesondere für elektrische oder elektronische Bauteile 11, wie Stromrichter, z. B. Gleichrichter, Wechselrichter od. dgl., bestimmt ist. Ein solches elektronisches Bauteil 11 ist in Fig. 1 nur schematisch angedeutet. Die Kühlvorrichtung 10 weist einen allgemein mit 12 bezeichneten Kühlkörper auf, mit dem das Bauteil 11 flächig in Berührung steht. Dieser Kühlkörper 12 besteht aus einer wärmeleitenden Platte 13 und aus einem als Kühler wirkenden Wärmeaustauscher 14, der in die Platte 13 eingebettet und von einem Kühlmedium durchströmt ist, das entsprechend dem Pfeil 15 in Fig. 3 dem Wärmeaustauscher 14 zugeführt und entsprechend dem Pfeil 16 abgeführt wird. Die Platte 13 ist aus einem Material mit hoher Wärmeleitfähigkeit, insbesondere aus Aluminium oder einer Aluminiumlegierung, gebildet. Sie enthält auf einer Breitseite 17, die in Fig. 1 nach rechts und zum Bauteil 11 weist, eine etwa nutartige Vertiefung 18, die sich vorzugsweise über die ganze Länge der Platte 13 durchgehend erstreckt. Innerhalb dieser Vertiefung 18 ist der Wärmeaustauscher 14 so angeordnet, dass dieser in wärmeleitender Verbindung mit der Platte 13 steht.

Der Wärmeaustauscher 14 ist beim ersten Ausführungsbeispiel als Kühlplatte 19 in Form einer Doppelplatte ausgebildet, die zwei in Abstand voneinander verlaufende Wände 20, 21 und im Zwischenraum zwischen den Wänden 20, 21 Kanäle 22 aufweist, die etwa mäanderförmig verlaufen, mit beiden Wänden 20, 21 in Berührung stehen und im Inneren von dem bei 15 eingeleiteten und bei 16 abgeführten Kühlmedium durchströmt sind.

Der Wärmeaustauscher 14, insbesondere die Kühlplatte 19, weist an zwei einander gegenüberliegenden Rändern jeweils einen quer abstehenden Steg 23, 24 auf, wobei statt dieser durchgehenden Stege 23, 24 auch einzelne quer abstehende Vorsprünge vorgesehen sein können. Die etwa nutartige Vertiefung 18 der Platte 13 weist an zwei einander gegenüberliegenden Nuträndern den Stegen 23, 24 zugeordnete Aufnahmen 25 bzw. 26 auf, die vorzugsweise aus hinterschnittenen Nuten am oberen bzw. unteren Rand der Vertiefung 18 gebildet sind. Diese Aufnahmen 25, 26 dienen der formschlüssigen Aufnahme der Stege 23, 24. Der Wärmeaustauscher 14 ist - ausgehend von der in Fig. 3 gezeigten horizontalen Ausrichtung - z. B. nach rechts und damit von einer Seite der Platte 13 her in deren nutartige Vertiefung 18 eingeschoben, wobei die Stege 23, 24 des Wärmeaustauschers 14 in die zugeordneten Aufnahmen 25 bzw. 26 eingreifen, wie insbesondere Fig. 3 erkennen lässt. Zwischen der Platte 13 und dem Wärmeaustauscher 14 sind schematisch angedeutete Federelemente 27, z.B. Blattfedern, Federstreifen od. dgl., angeordnet, die den Wärmeaustauscher 14 quer zu seiner Breitseite und so beaufschlagen, dass der Wärmeaustauscher 14 z. B. in Fig. 1 nach rechts hin federnd beaufschlagt ist. Die Federelemente 27 sind zwischen der Bodenfläche 28 der Vertiefung 18 und der dieser zugewandten Seite, z. B. der Wand 20, des Wärmeaustauschers 14 so angeordnet, dass die Federelemente 27 auf die Wand 20 federnd in Fig. 1 nach rechts hin einwirken. Der Wärmeaustauscher 14 verläuft mit seiner äußeren Seite 29, die der Bodenfläche 28 der Vertiefung 18 abgewandt ist und beim ersten Ausführungsbeispiel durch die entsprechende Außenfläche der äußeren Wand 21 gebildet ist, zumindest im wesentlichen flächenbündig mit der äußeren Breitseite 17 der Platte 13. Mit Vorteil wird der Wärmeaustauscher 14 mittels der Federelemente 27 in Fig. 1 nach rechts derart beaufschlagt, dass dessen äußere Seite 29 unter der Wirkung der Federkraft zumindest etwas über die genannte erste Breitseite 17 der Platte 13 übersteht, und zwar in dem in Fig. 3 gezeigten Zustand, bei dem am Kühlkörper 12 noch kein Bauteil 11 angebracht ist.

Das zu kühlende Bauteil 11 in Form eines Stromrichters, z. B. Gleichrichters, Wechselrichters od. dgl., ist lösbar auf einer Trägerplatte 40 befestigt. Diese Baueinheit, bestehend aus Trägerplatte 40 mit daran gehaltenem Bauteil 11, liegt mit der dem Bauteil 11 abgewandten Fläche 41 der Trägerplatte 40 an der ersten Breitseite 17 der Platte 13 und an der äußeren Seite 29 des Wärmeaustauschers 14 flächig und derart an, dass eine gute wärmeleitende Verbindung und damit eine gute Kontaktkühlung erfolgen kann. Die Platte 13 weist an beiden Randbereichen z. B. jeweils eine durchlaufende Hinterschneidungsnut 30, 31 für den Eingriff von Befestigungsmitteln 32 bzw. 33, z. B. von Schrauben, auf, mittels denen die das Bauteil 11 tragende Trägerplatte 40 an der Platte 13 befestigbar ist. Statt der durchlaufenden Hinterschneidungsnuten 30, 31 können an beiden Randbereichen der Platte 13 auch Durchlässe, z. B. Bohrungen, zum gleichen Zweck vorgesehen sein.

Die Platte 13 weist an beiden Randbereichen ferner Durchlässe 34, 35, z. B. Bohrungen, auf, die dem Durchgriff nicht weiter gezeigter Befestigungsmittel dienen, mittels denen die Platte 13 mitsamt der daran befestigten Trägerplatte 40 mit Bauteil 11 an einer nur schematisch angedeuteten Wand 36 eines Schaltschranks 37 derart befestigbar ist, dass das an der Platte 13 gehaltene mindestens eine zu kühlende Bauteil 11 in das Innere 38 des Schaltschranks 37 hinein vorsteht. Bei dem in Fig. 1 gezeigten ersten Ausführungsbeispiel liegt dabei die Platte 13 mit ihrer ersten Breitseite 17, an der die Trägerplatte 40 anliegt, an der Außenseite 39 der Wand 36 des Schaltschranks 37 an, so dass nur die Trägerplatte 40 mit dem Bauteil 11 daran in das Innere 38 des Schaltschranks 37 hineinragt, während die Platte 13 mit enthaltenem Wärmeaustauscher 14 bereits außerhalb des Flächenbereichs der Wand 36 verläuft.

Das in Fig. 2 gezeigte zweite Ausführungsbeispiel entspricht dem ersten Ausführungsbeispiel gänzlich und unterscheidet sich davon allein dadurch, dass bei diesem die Platte 13 mit ihrer der ersten Breitseite 17 gegenüberliegenden zweiten Breitseite 47 an der Innenseite 48 der Wand 36 des Schaltschranks 37 anliegt und befestigt ist. Hierbei befindet sich zusätzlich zur Trägerplatte 40 mit Bauteil 11 auch der Kühlkörper 12 im Inneren 38 des Schaltschranks 37.

In Fig. 1 und 2 ist angedeutet, dass die Kühlvorrichtung 10 ein Kühlaggregat 49 aufweist, das außerhalb des Schaltschranks 37 platziert ist und komplett oder mit einzelnen Bauteilen an der zweiten Breitseite 47 der Platte 13 gehalten ist. Der Wärmeaustauscher 14, insbesondere die Kühlplatte 19, ist beim ersten und zweiten Ausführungsbeispiel mit Vorteil als Verdampfer eines Kältekreislaufs ausgebildet, wobei die Kanäle 22 vom Kältemittel des Kältekreislaufs durchströmt sind. Bei einem anderen, nicht gezeigten Ausführungsbeispiel entfällt statt dessen das Kühlaggregat 49, wobei die Kühlplatte 19 von einem anderen Kühlmedium, z. B. Gas oder Flüssigkeit und hierbei z. B. Kühlwasser durchströmt ist, das aus einem Kühlwasserkreislauf zu diesem Zweck abgezweigt ist.

Die beschriebene Kühlvorrichtung 10 ermöglicht eine sehr intensive Kontaktkühlung des mindestens einen an der Trägerplatte 40 gehaltenen Bauteils 11, ohne dass hierzu das Innere 38 des Schaltschranks 37 gekühlt und/oder belüftet werden muss. Die erreichte gute Kontaktkühlung ist von der Luft und der Umwelt unabhängig. Da das zu kühlende Bauteil 11 auf der Trägerplatte 40 gehalten ist, ist der Kühlkörper 12 ein davon unabhängiges Bauteil, so dass bei etwaigen Wartungs- und/oder Reparaturarbeiten lediglich die Trägerplatte 40 mit dem mindestens einen Bauteil 11 daran durch Lösen der Befestigungselemente 32, 33 entfernt werden muss. Die Kühlvorrichtung 10 ermöglicht aufgrund des guten Flächenkontakts eine hochwirksame Kontaktkühlung, so dass dadurch ein besonderer Kühler für das Innere 38 des Schaltschranks 37 entbehrlich ist. Dies spart Aufwand und insbesondere Kosten.

Abweichend von den vorangehenden Ausführungsbeispielen kann sich die etwa nutartige Vertiefung 18 auf der anderen, der Trägerplatte 40 abgewandten Seite, so dass diese Vertiefung 18 und damit der darin eingebettete Wärmeaustauscher 14 der Trägerplatte 40 mit Bauteil 11 abgewandt ist. Die Trägerplatte 40 liegt mit der dem Bauteil 11 abgewandten Fläche 41 an der Breitseite 17 der Platte 13 flächig an. Dabei ist die Platte 13 an der Außenseite 39 der Wand 36 des Schaltschranks 37 befestigt, so dass lediglich die Trägerplatte 40 und das mindestens eine daran gehaltenen Bauteil 11 in das Innere 38 des Schaltschranks 37 hineinragen, während der Wärmeaustauscher 14 außerhalb des Inneren 38 des Schaltschranks 37 verläuft. Bei dieser Anordnung ergibt sich der Vorteil, dass der Wärmaustauscher 14 vom Äußeren des Schaltschranks 37 her frei und gut zugänglich ist.

Bei sämtlichen Ausführungsbeispielen besteht die Platte 13 z. B. aus einem Aluminiumbauteil, das aus stranggepreßtem Material hergestellt ist, wobei sich gleich bei der Herstellung z. B. die nutartige Vertiefung 18 und die Hinterschneidungsnuten 30, 31 mit einbringen lassen.

Die beschriebene Kühlvorrichtung 10 ist einfach im Aufbau, kostengünstig und ermöglicht eine sehr intensive Kontaktkühlung, die sonstige aufwendige zusätzliche Kühleinrichtungen insbesondere im Bereich des Schaltschranks 37 entbehrlich macht.

Nicht weiter gezeigt ist, dass an dem Kühlkörper 12, insbesondere an dessen Platte 13, eine Vielzahl einzelner Bauteile 11 angeordnet werden kann, vorzugsweise jeweils mit eigener Trägerplatte 40. Es ergibt sich damit ein allen Bauteilen gemeinsamer Kühlkörper, wodurch der Aufwand stark verringert wird. Nicht weiter gezeigt sind in den Zeichnungen die Leitungen für die Zuführung und die Abführung des Kühlmediums und die Anschlüsse, mittels denen der Wärmeaustauscher 14 an diese Leitungen angeschlossen ist. Diese das Kühlmedium führenden Leitungen können in vorteilhafter Weise außerhalb des Schaltschranks 37 angeordnet werden und verlaufen, so dass nicht die Gefahr besteht, dass Kühlmedium eventuell in das Innere 38 des Schaltschranks 37 gelangen kann. Von Vorteil ist ferner, dass der Anschluss des Kühlkörpers 12 an die das Kühlmedium führenden Leitungen bleibend ist und nicht gelöst werden muss, wenn etwa eines der Bauteile 11 entfernt oder gegen ein anderes Bauteil 11 ausgetauscht werden muss. In diesem Fall wird lediglich die Trägerplatte 40 mitsamt dem entsprechenden Bauteil 11 von der Platte 13 entfernt, während der Wärmeaustauscher 14 des Kühlkörpers 12 unverändert an die das Kühlmedium führenden Leitungen angeschlossen bleibt. Somit ist die Gefahr, dass eventuell Kühlmedium austritt und eventuell sogar in das Innere 38 des Schaltschranks 37 gelangt, ausgeschlossen.

## Patentansprüche

1. Kühlvorrichtung für elektrische oder elektronische Bauteile (11), die mit einem Kühlkörper (12) in Berührung stehen, der aus einer wärmeleitenden Platte (13) gebildet ist, die auf einer Breitseite (17 oder 47) eine nutartige Vertiefung (18) und innerhalb der Vertiefung (18) darin eingebettet einen von einem Kühlmedium durchströmten Wärmeaustauscher (14) als Kühler aufweist, der vom Kühlmedium durchströmte Kanäle (22) enthält,
**dadurch gekennzeichnet,**
**dass** der Wärmeaustauscher (14) als Kühlplatte (19) ausgebildet ist, die als Doppelplatte mit zwei in Abstand voneinander verlaufenden Wänden (20, 21) und mit im Zwischenraum zwischen den Wänden (20, 21) enthaltenen Kanälen (22) ausgebildet ist, die mäanderförmig verlaufen und die mit beiden Wänden (20, 21) in Berührung stehen und vom Kühlmedium durchströmt sind, dass die Kühlplatte (19) an zwei einander gegenüberliegenden Rändern jeweils quer abstehende einzelne Vorsprünge oder jeweils einen quer abstehenden Steg (23, 24) aufweist, dass die nutartige Vertiefung (18) an zwei einander gegenüberliegenden Nuträndern Aufnahmen (25, 26) für die Vorsprünge bzw. Stege (23, 24) der Kühlplatte (19) aufweist und dass die Kühlplatte (19) von einer Seite der Platte (13) her in deren nutartige Vertiefung (18) eingeschoben ist, wobei deren Vorsprünge bzw. Stege (23, 24) in die Aufnahmen (25, 26) eingreifen.

2. Kühlvorrichtung nach Anspruch 1,
**dadurch gekennzeichnet,**
**dass** die Platte (13) aus Aluminium oder einer Aluminiumlegierung gebildet ist.

3. Kühlvorrichtung nach einem der Ansprüche 1 oder 2,
**dadurch gekennzeichnet,**
**dass** sich die nutartige Vertiefung (18) über die ganze Länge der Platte (13) durchgehend erstreckt.

4. Kühlvorrichtung nach Anspruch 1,
**dadurch gekennzeichnet,**
**dass** die Aufnahmen (25, 26) in der Platte (13) aus hinterschnittenen Nuten der Vertiefung (18) gebildet sind.

5. Kühlvorrichtung nach einem der Ansprüche 1 bis 4,
**dadurch gekennzeichnet,**
**dass** zwischen der Platte (13) und dem Wärmeaustauscher (14) letzteren quer zu seiner Breitseite beaufschlagende Federelemente (27) angeordnet sind.

6. Kühlvorrichtung nach Anspruch 5,
**dadurch gekennzeichnet,**
**dass** die Federelemente (27) zwischen der Bodenfläche (28) der Vertiefung (18) und der dieser zugewandten Wand (20) des Wärmeaustauschers (14) angeordnet sind.

7. Kühlvorrichtung nach einem der Ansprüche 1 bis 6,
**dadurch gekennzeichnet,**
**dass** der Wärmeaustauscher (14) mit der äußeren Wand (21) der Doppelplatte, die der Bodenfläche (28) der Vertiefung (18) abgewandt ist, flächenbündig mit der Außenseite (17) der Platte (13) verläuft oder unter der Kraft der Federelemente (27) über diese Außenseite (17) vorsteht.

8. Kühlvorrichtung nach einem der Ansprüche 1 bis 7,
**dadurch gekennzeichnet,**
**dass** das mindestens eine zu kühlende Bauteil (11) auf einer Trägerplatte (40) lösbar befestigt ist und dass die Trägerplatte (40) mit der anderen, dem Bauteil (11) abgewandten Fläche (41) an einer Breitseite (17) der Platte (13) flächig anliegt und befestigt ist.

9. Kühlvorrichtung nach Anspruch 8,
**dadurch gekennzeichnet,**
**dass** die Trägerplatte (40) mit der dem Bauteil (11) abgewandten Fläche (41) an der ersten Breitseite (17) der Platte (13) und an der äußeren Seite (29) des Wärmeaustauschers (14) flächig anliegt und befestigt ist.

10. Kühlvorrichtung nach Anspruch 8,
**dadurch gekennzeichnet,**
**dass** die Trägerplatte (40) mit der dem Bauteil (11) abgewandten Fläche (41) an der Breitseite (17) der Platte (13) flächig anliegt und befestigt ist, die der äußeren Seite (29) des Wärmeaustauschers (14) gegenüberliegt.

11. Kühlvorrichtung nach einem der Ansprüche 8 bis 10,
**dadurch gekennzeichnet,**
**dass** die Platte (13) an beiden Randbereichen Durchlässe oder durchlaufende Hinterschneidungsnuten (30, 31) für den Eingriff von Befestigungselementen (32, 33) aufweist, mittels denen die das mindestens eine Bauteil (11) tragende Trägerplatte (40) an der Platte (13) befestigbar ist.

12. Kühlvorrichtung nach einem der Ansprüche 1 bis 11,
**dadurch gekennzeichnet,**
**dass** die Platte (13) an beiden Randbereichen Durchlässe (34, 35) für Befestigungselemente aufweist, mittels denen die Platte (13) derart, dass eine der beiden Breitseiten (17 oder 47) an der Innenseite (48) oder Außenseite (39) einer Schaltschrankwand (36) zugewandt ist, an einer Schaltschrankwand (36) derart befestigbar ist, dass das an der Platte (13) gehaltene mindestens eine zu kühlende Bauteil (11) in das Schaltschrankinnere (38) vorsteht.

13. Kühlvorrichtung nach einem der Ansprüche 1 bis 12,
**dadurch gekennzeichnet,**
**dass** an der einen Breitseite (47) der Platte (13), die dem daran gehaltenen Bauteil (11) gegenüberliegt, ein Kühlaggregat (49) angeordnet ist.

14. Kühlvorrichtung nach einem der Ansprüche 1 bis 13,
**dadurch gekennzeichnet,**
**dass** die Kühlplatte (19) als Verdampfer eines Kältekreislaufs ausgebildet ist und von einem Kältemittel durchströmt ist.

15. Kühlvorrichtung nach einem der Ansprüche 1 bis 14,
**dadurch gekennzeichnet,**
**dass** an dem Kühlkörper (12) eine Vielzahl einzelner Bauteile (11) jeweils mit oder ohne eigene Trägerplatte (40) angeordnet ist.

## Claims

1. Cooling apparatus for electrical or electronic components (11) which are in contact with a heat sink (12) which is formed from a thermally conductive plate (13) which has a groove-like depression (18) on one broad face (17 or 47) and, embedded within the depression (18), has a heat exchanger (14), through which a cooling medium flows, as a cooler which contains channels (22) through which the cooling medium flows,
**characterized in that**
the heat exchanger (14) is in the form of a cold plate (19), which is in the form of a double plate with two walls (20, 21) running at a distance from one another and with channels (22) contained in the space between the walls (20, 21), which channels (22) run in a meandering shape and make contact with the two walls (20, 21), and through which the cooling medium flows, **in that** the cold plate (19) has individual projections, which each project laterally, or in each case one web (23, 24), which projects laterally, on two mutually opposite edges, **in that** the groove-like depression (18) has holders (25, 26) on two mutually opposite groove edges for the projections or webs (23, 24) on the cold plate (19), and **in that** the cold plate (19) is inserted from one side of the plate (13) into its groove-like depression (18), with its projections or webs (23, 24) engaging in the holders (25, 26).

2. Cooling apparatus according to Claim 1,
**characterized in that**
the plate (13) is formed from aluminium or an aluminium alloy.

3. Cooling apparatus according to one of Claims 1 or 2,
**characterized in that**
the groove-like depression (18) extends continuously over the entire length of the plate (13).

4. Cooling apparatus according to Claim 1,
**characterized in that**
the holders (25, 26) in the plate (13) are formed from undercut grooves in the depression (18).

5. Cooling apparatus according to one of Claims 1 to 4,
**characterized in that**
spring elements (27), which are acted on transversely with respect to the broad face of the heat exchanger (14), are arranged between the plate (13) and the heat exchanger (14).

6. Cooling apparatus according to Claim 5,
**characterized in that**
the spring elements (27) are arranged between the bottom surface (28) of the depression (18) and that wall (20) of the heat exchanger (14) which faces it.

7. Cooling apparatus according to one of Claims 1 to 6,
**characterized in that**
the heat exchanger (14), together with the outer wall (21) of the double plate, which faces away from the bottom surface (28) of the depression (18), runs flush with the outer face (17) of the plate (13), or projects beyond this outer face (17) under the force of the spring elements (27).

8. Cooling apparatus according to one of Claims 1 to 7,
**characterized in that**
the at least one component (11) to be cooled is detachably mounted on a mount board (40), and **in that** the other surface (41) of the mount board (40) which faces away from the component (11) rests flat on and is attached to a broad face (17) of the plate (13).

9. Cooling apparatus according to Claim 8,
**characterized in that**
that surface (41) of the mount board (40) which faces away from the component (11) rests flat on and is attached to the first broad face (17) of the plate (13) and the outer face (29) of the heat exchanger (14).

10. Cooling apparatus according to Claim 8,
**characterized in that**
that surface (41) of the mount board (40) which faces away from the component (11) rests flat on and is attached to the broad face (17) of the plate (13), which is opposite the outer face (29) of the heat exchanger (14).

11. Cooling apparatus according to one of Claims 8 to 10,
**characterized in that**,
on both edge areas, the plate (13) has apertures or continuous undercut grooves (30, 31) for the engagement of attachment elements (32, 33), by means of which the mount board (40) to which the at least one component (11) is fitted can be attached to the plate (13).

12. Cooling apparatus according to one of Claims 1 to 11,
**characterized in that**,
on both edge areas, the plate (13) has apertures (34, 35) for attachment elements, by means of which the plate (13) can be attached to a switching cabinet wall (36), in such a manner that one of the two broad faces (17 or 47) faces the inner face (48) or the outer face (39) of a switching cabinet wall (36), in such a manner that the at least one component (11) that is to be cooled and is held on the plate (13) projects into the switching cabinet interior (38).

13. Cooling apparatus according to one of Claims 1 to 12,
**characterized in that**,
a refrigeration unit (49) is arranged on one broad face (47) of the plate (13), which is opposite the component (11) which is held on it.

14. Cooling apparatus according to one of Claims 1 to 13,
**characterized in that**
the cold plate (19) is in the form of an evaporator for a cooling circuit, and a cooling agent flows through it.

15. Cooling apparatus according to one of Claims 1 to 14,
**characterized in that**
a multiplicity of individual components (11), each with or without their own mount board (40), are arranged on the heat sink (12).

## Revendications

1. Dispositif de refroidissement pour composants électriques ou électroniques (11), qui sont en contact avec un corps de refroidissement (12) qui est formé d'une plaque thermoconductrice (13) qui présente sur un côté large (17 ou 47) un renfoncement en forme de rainure (18) et à l'intérieur du renfoncement (18), encastré dans celui-ci, un échangeur de chaleur (14) parcouru par un réfrigérant et servant de refroidisseur qui contient des canaux (22) parcourus par le réfrigérant,
**caractérisé en ce que**
l'échangeur de chaleur (14) est réalisé sous forme de plaque de refroidissement (19) qui est réalisée sous forme de double plaque avec deux parois (20, 21) s'étendant à distance l'une de l'autre et avec des canaux (22) contenus dans l'espace intermédiaire entre les parois (20, 21), lesquels s'étendent en méandres, sont en contact avec les deux parois (20, 21) et sont parcourus par le réfrigérant, **en ce que** la plaque de refroidissement (19) présente au niveau de deux bords opposés à chaque fois des saillies individuelles dépassant transversalement ou à chaque fois une nervure dépassant transversalement (23, 24), **en ce que** le renfoncement en forme de rainure (18) présente au niveau de deux bords de rainure opposés des logements (25, 26) pour des saillies ou des nervures (23, 24) de la plaque de refroidissement (19) et **en ce que** la plaque de refroidissement (19) est enfoncée depuis un côté de la plaque (13) dans son renfoncement en forme de rainure (18), ses saillies ou nervures (23, 24) venant en prise dans les logements (25, 26).

2. Dispositif de refroidissement selon la revendication 1,
**caractérisé en ce que**
la plaque (13) est en aluminium ou un alliage d'aluminium.

3. Dispositif de refroidissement selon l'une quelconque des revendications 1 ou 2,
**caractérisé en ce que**
le renfoncement en forme de rainure (18) s'étend en continu sur toute la longueur de la plaque (13).

4. Dispositif de refroidissement selon la revendication 1,
**caractérisé en ce que**
les logements (25, 26) dans la plaque (13) sont formés par des rainures en contre-dépouille du renfoncement (18).

5. Dispositif de refroidissement selon l'une quelconque des revendications 1 à 4,
**caractérisé en ce que**
des éléments de ressort (27) sollicitant l'échangeur de chaleur (14) transversalement à son côté large sont disposés entre la plaque (13) et l'échangeur de chaleur (14).

6. Dispositif de refroidissement selon la revendication 5,
**caractérisé en ce que**
les éléments de ressort (27) sont disposés entre la face de fond (28) du renfoncement (18) et la paroi (20) de l'échangeur de chaleur (14) tournée vers ce renfoncement.

7. Dispositif de refroidissement selon l'une quelconque des revendications 1 à 6,
**caractérisé en ce que**
l'échangeur de chaleur (14), avec la paroi extérieure (21) de la double plaque qui est opposée à la face de fond (28) du renfoncement (18), s'étend en affleurement de surface avec le côté extérieur (17) de la plaque (13) ou dépasse de ce côté extérieur (17) sous l'effet de la force des éléments de ressort (27).

8. Dispositif de refroidissement selon l'une quelconque des revendications 1 à 7,
**caractérisé en ce que**
l'au moins un composant à refroidir (11) est fixé de manière détachable sur une plaque de support (40) et **en ce que** la plaque de support (40) s'applique à plat et est fixée avec l'autre face (41) opposée au composant (11) contre un côté large (17) de la plaque (13).

9. Dispositif de refroidissement selon la revendication 8,
**caractérisé en ce que**
la plaque de support (40) s'applique à plat et est fixée avec la face (41) opposée au composant (11) contre le premier côté large (17) de la plaque (13) et contre le côté extérieur (29) de l'échangeur de chaleur (14).

10. Dispositif de refroidissement selon la revendication 8,
**caractérisé en ce que**
la plaque de support (40) s'applique à plat et est fixée avec la face (41) opposée au composant (11) contre le côté large (17) de la plaque (13) qui est opposé au côté extérieur (29) de l'échangeur de chaleur (14).

11. Dispositif de refroidissement selon l'une quelconque des revendications 8 à 10,
**caractérisé en ce que**
la plaque (13) présente au niveau de deux régions de bord, des passages ou des rainures en contre-dépouille continues (30, 31) pour l'engagement d'éléments de fixation (32, 33) au moyen desquels la plaque de support (40) portant l'au moins un composant (11) peut être fixée sur la plaque (13).

12. Dispositif de refroidissement selon l'une quelconque des revendications 1 à 11,
**caractérisé en ce que**
la plaque (13) présente au niveau de deux régions de bord des passages (34, 35) pour des éléments de fixation au moyen desquels la plaque (13) peut être fixée de telle sorte que l'un des deux côtés larges (17 ou 47) soit tourné vers le côté intérieur (48) ou le côté extérieur (39) d'une paroi d'armoire de distribution (36), contre une paroi d'armoire de distribution (36) de telle sorte que l'au moins un composant (11) à refroidir maintenu sur la plaque (13) dépasse à l'intérieur de l'armoire de distribution (38).

13. Dispositif de refroidissement selon l'une quelconque des revendications 1 à 12,
**caractérisé en ce**
**qu'**une unité de refroidissement (49) est disposée sur l'un des côtés larges (47) de la plaque (13) qui est opposé au composant (11) maintenu sur celle-ci.

14. Dispositif de refroidissement selon l'une quelconque des revendications 1 à 13,
**caractérisé en ce que**
la plaque de refroidissement (19) est réalisée sous forme d'évaporateur d'un circuit de refroidissement et est parcourue par un agent frigorigène.

15. Dispositif de refroidissement selon l'une quelconque des revendications 1 à 14,
**caractérisé en ce**
**qu'**une pluralité de composants individuels (11) est disposée sur le corps de refroidissement (12) à chaque fois avec ou sans plaque de support propre (40).
